# FASCICULE DE BREVET EUROPEEN

(11) **EP 3 047 535 B1**
(45) Date de publication et mention de la délivrance du brevet: **14.03.2018**
(21) Numéro de dépôt: 14767037.6
(22) Date de dépôt: 19.09.2014
(51) Int. Cl.: H01P 5/08, H04B 7/00

(54) **DISPOSITIF DE JONCTION ENTRE UNE LIGNE DE TRANSMISSION IMPRIMÉE ET UN GUIDE D'ONDES DIÉLECTRIQUE**
VORRICHTUNG ZUR VERBINDUNG ZWISCHEN EINER GEDRUCKTEN ÜBERTRAGUNGSLEITUNG UND EINEM DIELEKTRISCHEN WELLENLEITER
JUNCTION DEVICE BETWEEN A PRINTED TRANSMISSION LINE AND A DIELECTRIC WAVEGUIDE

(30) Priorité: 19.09.2013 FR 1359045
(43) Date de publication de la demande: 27.07.2016
(73) Titulaire: Institut Télécom - Télécom Bretagne, 29238 Brest Cedex 3 (FR)
(72) Inventeur: COUPEZ, Jean-Philippe, F-29200 Brest (FR); CHENU, Sylvain, F-29200 Brest (FR)
(74) Mandataire: Bell, Mark
(86) Numéro de dépôt international: PCT/EP2014/070055
(87) Numéro de publication internationale: WO 2015/040192

(56) Documents cités:
- FR-A1- 2 849 720
- US-A- 2 979 676
- US-A- 3 932 823
- US-A1- 2002 047 038

## Description

### DOMAINE TECHNIQUE GENERAL

L'invention concerne une transition d'une ligne de transmission vers un guide d'ondes et plus particulièrement une transition entre une ligne de transmission imprimée sur un substrat et un guide d'ondes rectangulaire.

### ETAT DE LA TECHNIQUE

On connait plusieurs types de transitions entre une ligne de transmission imprimée sur un substrat et un guide d'ondes rectangulaire.

Un premier type repose sur des montages basés sur une configuration perpendiculaire entre le plan dans lequel est contenu le substrat et l'axe longitudinal du guide d'ondes. Dans ce cas, le substrat supportant la ligne de transmission obture complètement l'extrémité du guide d'ondes et le couplage électromagnétique entre cette ligne et ce guide est alors assuré soit par :
- Un ou des évidement(s) aménagé(s) dans le ou les plans de masse du circuit imprimé, qui constituent des fenêtres ouvertes vers le guide, comme par exemple dans le document US 2011/0267153;
- Un ou des élément(s) rayonnant(s), de type antenne patch par exemple, orienté(s) pour rayonner vers l'intérieur du guide, comme illustré notamment dans le document US 5 793 263 ;
- Un élément équivalent à une sonde d'excitation, positionné en entrée du guide, comme par exemple dans le document US 8 022 784 ;
- Ou toute combinaison possible de ces éléments, voire avec d'autres éléments tels que des cavités ou des arêtes (en anglais, *«ridges»)* insérés dans le guide d'ondes, comme par exemple dans le document US 6 794 950.

Un problème avec ce premier type de transition est que la géométrie perpendiculaire entre le substrat et le guide, ainsi que les divers moyens de couplage utilisés entrainent de sérieux problèmes quant à la facilité de montage d'une telle structure, en particulier en ce qui concerne la maîtrise fine du positionnement entre les divers éléments constituant de la transition.

Un second type de transitions consiste en des configurations où :
- soit le substrat est directement plaqué sur l'une des faces latérales du guide d'ondes, typiquement sa face inférieure ou supérieure ;
- soit le guide est lui-même reporté sur la surface d'un circuit imprimé.

Dans tous les cas, le couplage de la ligne de transmission imprimée vers le guide d'ondes est réalisé à partir de motifs inscrits conjointement sur le substrat et la face latérale du guide et positionnés en regard les uns par rapport aux autres. Ces motifs peuvent être équivalents à des fentes ou à des électrodes, comme par exemple dans les documents US 6 977 560, US 8 368 482, WO 2010/130293 et US 7 132 905. Toutes ces solutions nécessitent donc de graver directement les motifs de couplage sur le guide d'ondes et de les aligner, voire de les espacer, très précisément avec les motifs inscrits sur le circuit imprimé, d'où de réelles difficultés de réalisation et de montage.

Un troisième type de transitions correspond à des solutions où le couplage entre la ligne de transmission et le guide d'ondes est obtenu par un système de sonde ou d'antenne connecté à l'extrémité de la ligne et plongeant à l'intérieur du guide. Cette sonde ou antenne est alors combinée à d'autres éléments réalisés au sein du guide, tels que des cavités ou des *ridges.* Les documents US 3 146 410, US 6 002 305 et US 7 746 191 en sont quelques exemples. Le principal inconvénient pour ce type de solution repose sur la nécessité d'insérer physiquement un plongeur dans le guide, avec toutes les difficultés de réalisation, de montage et de positionnement associées.

Un quatrième type repose également sur un principe d'insertion à l'intérieur du guide d'ondes d'un substrat sur lequel est imprimée la ligne de transmission. Le substrat est alors soit partiellement inséré dans le guide à partir de son extrémité ouverte, soit complètement inséré dans le plan E de ce guide. Les motifs imprimés sur le substrat sont soit de type antenne, soit de type *taper* (transition réalisée sur le substrat entre, par exemple, une ligne micro-ruban et une ligne fente). Les documents US 3 732 508, US 4 260 964 et US 8 305 280 décrivent des exemples d'une telle transition. Comme pour le troisième type, la difficulté majeure de cette famille de solutions correspond à l'insertion de tout ou partie du substrat supportant les motifs imprimés dans le guide d'ondes.
Enfin, un cinquième et dernier type est fondé sur l'utilisation d'une structure de type arête effilée ou bien « *taperisée* », le plus souvent réalisée à l'intérieur d'un guide d'ondes à air, en contact électrique avec l'extrémité d'une ligne de transmission gravée sur un substrat. Les documents US 6 265 950 et JP 2002344212 en illustrent deux exemples. Pour ce type de transitions à *ridge,* une solution alternative, où le guide et le substrat sont alors réalisés collectivement dans un même matériau diélectrique, est décrite dans le document US 7 382 212 (également publié comme FR2849720). Dans les documents US 6 265 950 et JP 2002344212, la transition nécessite un chevauchement précis du *ridge* et de l'extrémité de la ligne et le *ridge* est réalisé sous la forme d'une excroissance s'étendant dans le volume interne du guide d'ondes à air. Dans le document US 7 382 212, l'unicité du matériau diélectrique pour la réalisation conjointe du guide et du substrat ne permet pas de combiner une telle transition avec un circuit imprimé réalisé sur tout autre substrat diélectrique.

Compte tenu des différents types de transitions connus il existe un réel besoin de simplifier la réalisation d'une transition ainsi que de faciliter son report en surface sur tout type de circuits imprimés.

### PRESENTATION DE L'INVENTION

L'invention répond au besoin ci-dessus mentionné et propose un dispositif de transition entre une ligne de transmission imprimée sur un substrat diélectrique et un guide d'ondes rectangulaire comprenant une face avant formant entrée du guide d'ondes, une face arrière parallèle à la face avant et formant sortie du guide d'ondes, une face inférieure, une face supérieure parallèle à la face inférieure, les faces inférieure et supérieure s'étendant entre les faces avant et arrière, le guide d'ondes étant un bloc en matériau diélectrique dont les faces sont intégralement métallisées exceptées la face avant et la face arrière, le dispositif de transition comprenant :
une cavité tridimensionnelle formée dans le volume du guide d'ondes entre l'entrée du guide d'ondes, formant en outre entrée de la cavité, et la face arrière en s'évasant, la cavité étant à une hauteur d'entrée de la face inférieure du guide d'ondes et se terminant à une distance de l'entrée de la cavité à une hauteur de sortie supérieure à la hauteur d'entrée ;
une connexion électrique s'étendant à partir de la ligne de transmission le long de la face avant du guide d'ondes jusqu'à l'entrée de la cavité tridimensionnelle.

L'invention est avantageusement complétée par les caractéristiques suivantes, prises seules ou en une quelconque de leur combinaison techniquement possible :
- la cavité présente une largeur d'entrée et une largeur de sortie supérieure à la largeur d'entrée de sorte que l'évasement de la cavité conduit à ce que le long du guide d'ondes, le couple hauteur/largeur est croissant ;
- le substrat diélectrique comprend une face avant comprenant un dépôt conducteur formant un plan de masse, et une face arrière parallèle à la face avant sur laquelle la ligne de transmission est imprimée, le guide d'ondes étant disposé sur le plan de masse, le substrat diélectrique comprenant un évidement configuré pour amener la connexion électrique à l'entrée de la cavité, le guide d'ondes comprenant sur sa face inférieure une zone locale au niveau de la connexion électrique dépourvue de métallisation afin d'empêcher tout contact électrique entre la connexion électrique et la face inférieure du guide d'ondes ;

- le substrat diélectrique comprend une face avant comprenant un dépôt conducteur formant un plan de masse, et une face arrière parallèle à la face avant sur laquelle la ligne de transmission est imprimée, le guide d'ondes étant disposé sur la face arrière, la face inférieure du guide d'ondes étant connectée au plan de masse par l'intermédiaire d'une pluralité de vias métallisés traversant le substrat diélectrique, la face inférieure du guide d'ondes comprenant une zone locale au niveau de la connexion électrique dépourvue de métallisation afin d'empêcher tout contact électrique entre la connexion électrique et la face inférieure du guide d'ondes ;
- le substrat diélectrique comprend une face avant sur laquelle sont imprimés la ligne de transmission et un dépôt conducteur formant plan de masse en contact avec la face inférieure du guide d'ondes, le plan de masse et la ligne de transmission étant coplanaires, la connexion électrique étant connectée à l'extrémité de la ligne de transmission, la face inférieure du guide d'ondes comprenant une zone locale au niveau de la connexion électrique dépourvue de métallisation afin d'empêcher tout contact électrique entre la connexion électrique et la face inférieure du guide d'ondes ;
- un support métallique sur lequel est disposé le guide d'ondes, la face inférieure du guide d'ondes étant connectée audit support métallique, support métallique sur lequel est également disposé le substrat diélectrique, l'élément conducteur étant connecté à l'entrée du guide d'ondes ;
- la cavité tridimensionnelle comprend un profil d'entrée en entrée du guide d'ondes en forme de U ;
- la cavité tridimensionnelle comprend un profil d'entrée à bords linéaires obliques, à bords concaves, à bords convexes, à bords sinueux ;
- la cavité tridimensionnelle présente un profil d'évasement linéaire, concave, convexe, sinueux, ledit profil d'évasement étant caractéristique de la variation de la largeur de la cavité entre la largeur d'entrée et la largeur de sortie ;
- la cavité tridimensionnelle comprend un profil latéral linéaire, concave, convexe, sinueux, ledit profil latéral étant caractéristique de la variation de la hauteur de la cavité entre la hauteur d'entrée et la hauteur de sortie.

Comparativement aux dispositifs de transitions connus, le dispositif de transition de l'invention permet de faciliter aussi bien la réalisation du dispositif que le report en surface de celui-ci sur tout type de circuits imprimés.

En particulier, le couplage entre la ligne de transmission et le guide d'ondes, par une simple connexion électrique directe entre les deux éléments, rend cette solution particulièrement robuste et peu sensible aux dispersions technologiques et de montage. D'autres avantages procurés par le dispositif de l'invention sont les suivants :
- simplicité de réalisation de la cavité tridimensionnelle inscrite dans le volume du guide d'ondes, par usinage ou par moulage du matériau diélectrique brut, puis métallisation externe globale de la structure, excepté au niveau des deux sections transverses aux extrémités du guide ainsi qu'au niveau de la zone locale non métallisée aménagée dans la face inférieure du guide ;
- multiples paramètres de liberté dans la conception d'une telle structure de transition, en particulier au niveau du choix de la géométrie de la surface tridimensionnelle de la cavité et de ses dimensions.

En outre, l'invention conduit également à de bonnes performances électriques, notamment en ce qui concerne la largeur de la bande passante du dispositif, tout en ayant une structure de dimension relativement compacte.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1 illustre une vue en perspective d'un dispositif de transition selon un premier mode de réalisation de l'invention ;
- les figures 2a, 2b, 2c et 2d illustrent respectivement une vue de dessous, une vue de face une vue de côté et une vue de dessus d'un guide d'ondes d'un dispositif de transition selon le premier mode de réalisation de l'invention ;
- les figures 3a, 3b et 3c illustrent respectivement une vue de la coupe AA', de la coupe BB' et de la coupe CC' de la figure 2d ;
- les figures 4a, 4b, 4c, 4d et 4e illustrent plusieurs variantes du profil d'entrée d'une cavité d'un dispositif de jonction conforme à l'invention ;
- les figures 5a, 5b, 5c et 5d illustrent plusieurs variantes du profil d'évasement d'une cavité d'un dispositif de jonction conforme à l'invention ;
- les figures 6a, 6b, 6c et 6d illustrent plusieurs variantes du profil latéral d'une cavité d'un dispositif de jonction conforme à l'invention ;
- les figures 7a et 7b illustrent respectivement une vue de côté et une vue de face du dispositif de transition selon le premier mode de réalisation de l'invention ;
- les figures 8a et 8b illustrent respectivement une vue de côté et une vue de face du dispositif de transition selon un second mode de réalisation de l'invention ;
- les figures 9a et 9b illustrent respectivement une vue de côté et une vue de face du dispositif de transition selon un troisième mode de réalisation de l'invention ;
- les figures 10a et 10b illustrent respectivement une vue de côté et une vue de face du dispositif de transition selon un quatrième mode de réalisation de l'invention ;
- la figure 11 illustre les coefficients de transmission et de réflexion d'un prototype simulé et réalisé, celui-ci étant constitué de deux dispositifs de transition selon le premier mode de réalisation montés en « tête-bêche ».

Sur l'ensemble des figures les éléments similaires portent des références identiques.

### DESCRIPTION DETAILLEE DE L'INVENTION

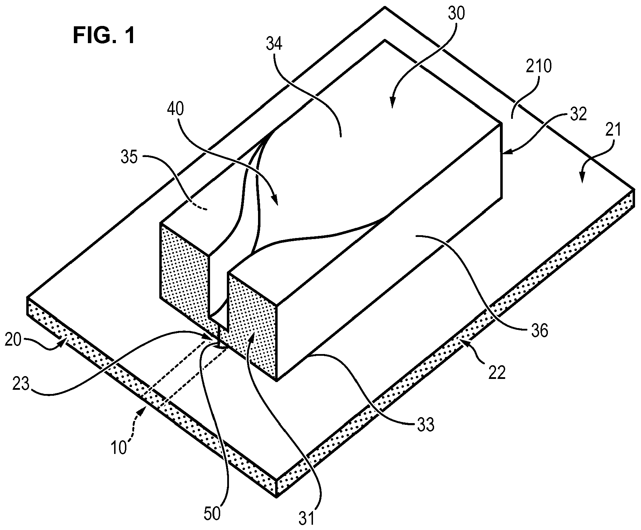

La **figure 1** illustre un dispositif de transition entre une ligne de transmission 10 imprimée sur un substrat diélectrique 20 et un guide d'ondes 30 rectangulaire selon un premier mode de réalisation de l'invention.

Le substrat diélectrique 20 comprend une face avant 21 comprenant un dépôt conducteur 210 formant un plan de masse, et une face arrière 22 parallèle à la face avant sur laquelle la ligne de transmission 10 est imprimée.

Le guide d'ondes 30 diélectrique est rectangulaire et comprend une face avant 31 formant entrée du guide d'ondes, une face arrière 32 parallèle à la face avant et formant sortie du guide d'ondes, une face inférieure 33, une face supérieure 34 parallèle à la face inférieure, les faces inférieure 33 et supérieure 34 s'étendant entre les faces avant 31 et arrière 32.

En outre, le guide d'ondes rectangulaire comprend deux faces latérales 35, 36 parallèles l'une de l'autre s'étendant respectivement entre les faces supérieure 34 et inférieure 33.

Le guide d'ondes est en matériau diélectrique et est un bloc parallélépipédique plein. Le matériau du guide d'ondes est de préférence de type plastique ou mousse plastique avec des caractéristiques électriques telles que la permittivité relative εᵣ soit la plus proche possible de 1 et les pertes diélectriques tgδ très proches de zéro.

Le guide d'ondes est en outre métallisé sur toutes ses faces excepté la face avant et la face arrière de ce dernier. Ainsi sont métallisées : les faces inférieure 33 et supérieure 34 et les deux faces latérales 35, 36. Le dispositif de transition comprend en outre une cavité tridimensionnelle 40 (en anglais, « *taper»*) formée dans le volume du guide d'ondes 30 entre l'entrée 31 du guide d'ondes, formant en outre entrée de la cavité, et la face arrière 32 en s'évasant le long d'un axe longitudinal (non représenté) du guide d'ondes 30.

La cavité tridimensionnelle 40 peut être réalisée dans le volume du guide d'ondes 30, soit par usinage ou par moulage.

De manière avantageuse, afin de coupler la ligne de transmission 10 et le guide d'ondes 30, le dispositif comprend une connexion électrique 50 qui s'étend à partir de la ligne de transmission 10 le long de la face avant du guide d'ondes et ce jusqu'à l'entrée 31 de la cavité 40 tridimensionnelle.

En outre, le substrat diélectrique comprend un évidement 23 configuré pour amener la connexion électrique 50 à l'entrée de la cavité 40.

Comme on l'aura compris le dispositif de jonction est de type CMS (Composant Monté en Surface) de sorte qu'il peut être facilement reporté sur un substrat diélectrique (c'est-à-dire un circuit intégré), voire sur un support métallique.

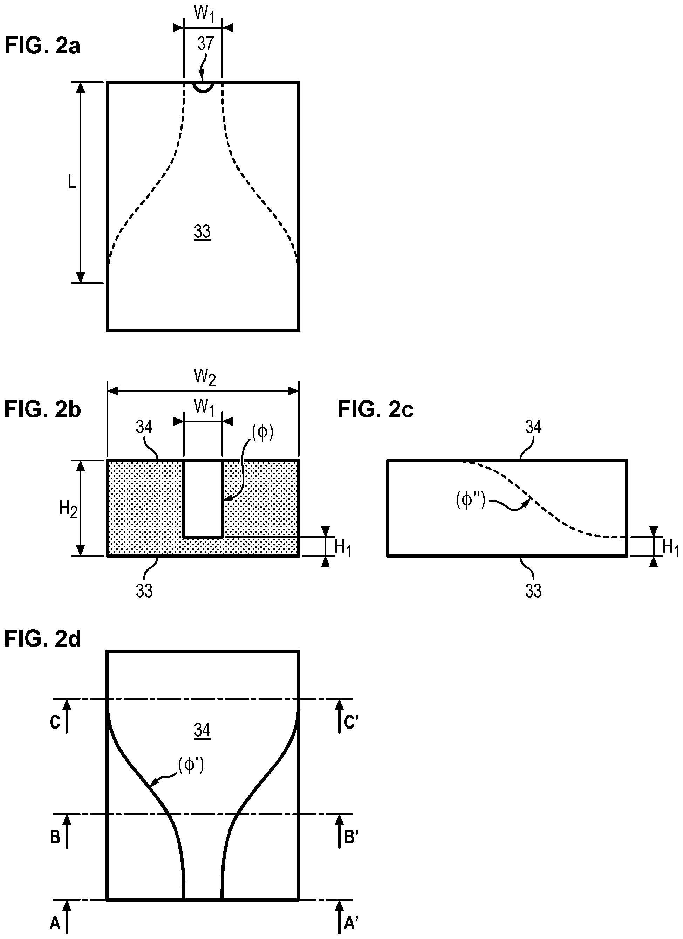

On a illustré sur **les** **figures 2a, 2b, 2c** et **2d** respectivement une vue de dessous, une vue de face, une vue de côté et une vue de dessus d'un guide d'ondes d'un dispositif de transition selon le premier mode de réalisation de l'invention.

Sur la vue de face, la cavité tridimensionnelle présente un profil d'entrée φ (à bords linéaires verticaux sur la figure 2b). En particulier il s'agit d'une encoche aménagée dans le guide d'ondes 30, de largeur W₁ à sa base et ayant sous celle-ci une épaisseur de matériau diélectrique du guide d'ondes égale à H₁.

La cavité est à une hauteur d'entrée H1 de la face inférieure 33 du guide d'ondes 30 et se termine à une distance L de l'entrée de la cavité à une hauteur de sortie H2 supérieure à la hauteur d'entrée H1.

Les valeurs de largeur W₁ et hauteur H₁ sont choisies pour correspondre aux caractéristiques géométriques d'une ligne de transmission de type micro-ruban d'impédance caractéristique Z_{c} (typiquement 50Ω), qui serait réalisée sur un substrat diélectrique de même matériau diélectrique que celui utilisé pour le guide d'ondes et d'épaisseur H₁, et dont la largeur du micro-ruban serait égale à W₁. Ce choix d'impédance caractéristique, et en conséquence le choix des dimensions W₁ et H₁, permet d'assurer les conditions d'une bonne adaptation avec la ligne de transmission imprimée, elle-même d'impédance caractéristique Z_{c}.

Par la suite la cavité se développe sur une longueur L selon l'axe longitudinal du guide d'ondes selon un profil d'évasement φ' (sinueux sur la figure 2d).

Comme mentionnée plus haut l'entrée de la cavité est à une hauteur d'entrée H₁ de la face inférieure 33 du guide d'ondes 30 et se termine à une distance L de l'entrée de la cavité à une hauteur de sortie H₂ supérieure à la hauteur d'entrée H1 et présente un profil latéral φ" (sinueux sur la figure 2c).

De manière préférée, la cavité 40 se termine à une distance L de l'entrée par une section transverse, dont les dimensions W₂ et H₂ correspondent à celles du guide d'ondes rectangulaire dans lequel est formée cette dernière.

Avantageusement la longueur L de la cavité ainsi que l'allure des profils d'entrée φ, latéral φ" et d'évasement φ' permettent d'adapter progressivement les dimensions d'entrée de la cavité W₁, H₁ à ses dimensions de sortie W₂, H₂.

Ainsi, la cavité présente un couple hauteur/largeur qui croit le long de la longueur L du guide d'ondes 30.

En outre, afin d'éviter tout contact électrique entre la connexion électrique 50 et la face inférieure du guide d'ondes métallisée, une zone locale 37, autour de la connexion électrique, est dépourvue de métallisation.

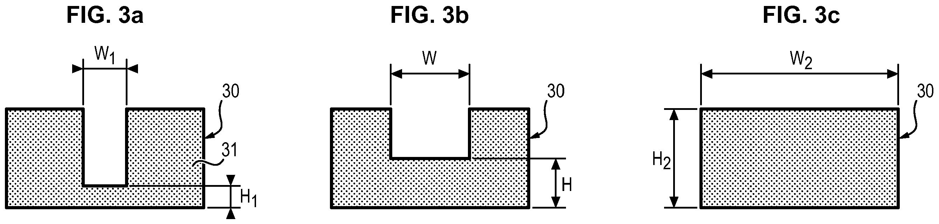

On a illustré sur les **figures 3a, 3b** et **3c** respectivement une vue de la coupe AA', de la coupe BB' et de la coupe CC' de la figure 2d sur lesquelles est illustré, à nouveau, l'évasement de la cavité. La largeur W₁ en entrée est inférieure à la largeur W prise dans un plan de coupe intermédiaire du guide d'ondes 30 et encore inférieure à la largeur W₂ prise en sortie de la cavité 40.

De même la hauteur H₁ en entrée est inférieure à la hauteur H prise dans un plan de coupe intermédiaire selon la coupe BB' et encore inférieure à la hauteur H₂ prise en sortie de la cavité 40. Comme on l'a donc mentionné, la cavité présente un couple hauteur/largeur qui croit le long de la longueur L du guide d'ondes 30.

Les profils d'entrée, d'évasement et latéral peuvent prendre plusieurs formes.

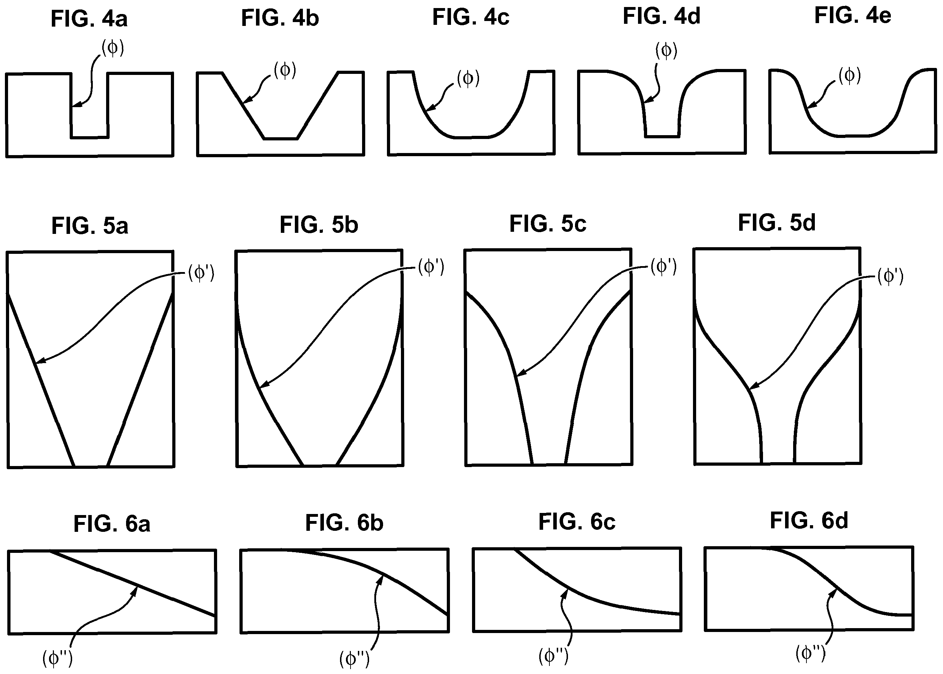

Le profil d'entrée peut être à bords linéaires verticaux (**figure 4a**), à bords linéaires obliques (**figure 4b**), à bords concaves (**figure 4c**), à bords convexes (**figure 4d**), à bords sinueux (**figure 4e**).

Le profil d'évasement peut être linéaire (**figure 5a****),** concave (**figure 5b**), convexe (**figure 5c**) ou sinueux (**figure 5d**).

Le profil latéral peut être linéaire (**figure 6a**), concave (**figure 6b**), convexe (**figure 6c**) ou sinueux (**figure 6d**).

On décrit maintenant plusieurs modes de réalisation d'un dispositif de transition conforme à l'invention.

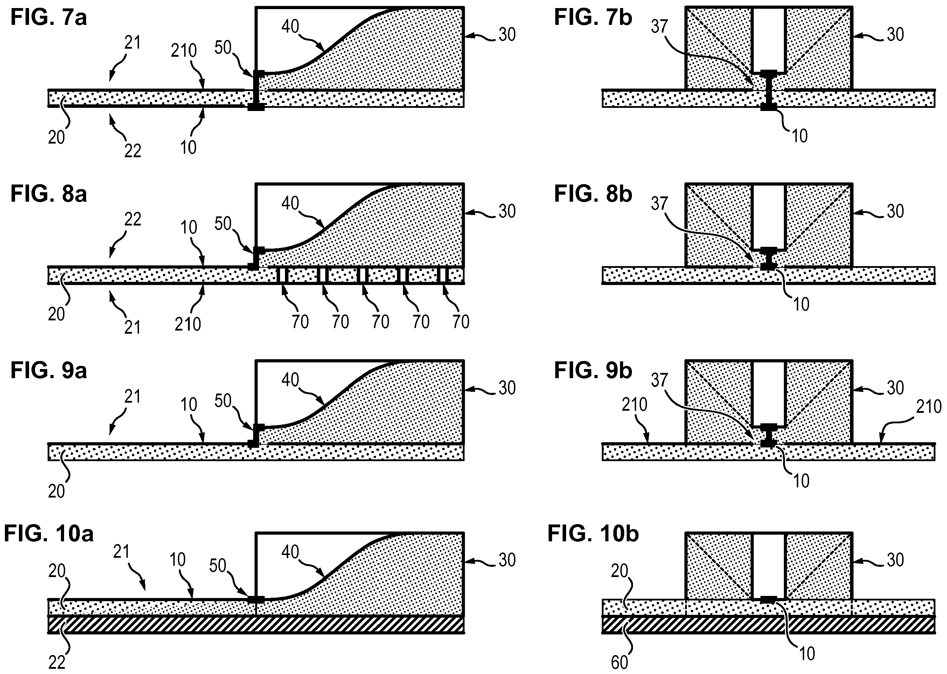

Les **figures 7a** et **7b** illustrent respectivement une vue de côté et de face d'un dispositif de transition selon le premier mode de réalisation de l'invention.

Selon ce premier mode de réalisation le substrat diélectrique 20 comprend une face avant 21 comprenant un dépôt conducteur 210 formant un plan de masse, et une face arrière 22 parallèle à la face avant sur laquelle la ligne de transmission 10 est imprimée. En outre, le guide d'ondes 30 est disposé sur le plan de masse 210 et le substrat diélectrique comprend un évidement 23 configuré pour amener la connexion électrique 50 à l'entrée de la cavité 40. En outre, le guide d'ondes comprend sur sa face inférieure une zone locale 37 au niveau de la connexion électrique 50 dépourvue de métallisation afin d'empêcher tout contact électrique entre la connexion électrique et la face inférieure du guide d'ondes.

Les **figures 8a** et **8b** illustrent respectivement une vue de côté et de face d'un dispositif de transition selon un second mode de réalisation de l'invention.

Selon ce second mode de réalisation, le substrat diélectrique 20 comprend une face avant 21 comprenant un dépôt conducteur 210 formant un plan de masse, et une face arrière 22 parallèle à la face avant sur laquelle la ligne de transmission 10 est imprimée. En outre, le guide d'ondes 30 est disposé sur la face arrière du substrat diélectrique. Afin de connecter la face inférieure du guide d'ondes au plan de masse du substrat diélectrique, le dispositif comprend une pluralité de vias 70 métallisés traversant le substrat diélectrique et reliant électriquement le plan de masse à la face inférieure du guide d'ondes. En outre, le guide d'ondes comprend sur sa face inférieure une zone locale 37 au niveau de la connexion électrique 50 dépourvue de métallisation afin d'empêcher tout contact électrique entre la connexion électrique et la face inférieure du guide d'ondes.

Les **figures 9a** et **9b** illustrent respectivement une vue de côté et de face d'un dispositif de transition selon un troisième mode de réalisation de l'invention.

Selon ce troisième mode de réalisation, le substrat diélectrique 20 comprend une face avant sur laquelle sont imprimés de manière coplanaire, la ligne de transmission 10 et un dépôt conducteur 210 formant plan de masse en contact avec la face inférieure du guide d'ondes 30. En outre, le guide d'ondes est disposé sur le plan de masse et la face inférieure du guide d'ondes comprend une zone locale 37 au niveau de la connexion électrique 50 dépourvue de dépôt conducteur afin d'empêcher tout contact électrique entre la connexion électrique 50 et la face inférieure du guide d'ondes.

Les **figures 10a** et **10b** illustrent respectivement une vue de côté et de face d'un dispositif de transition selon un quatrième mode de réalisation de l'invention.

Selon ce quatrième mode de réalisation, le dispositif comprend un support 60 métallique sur lequel est disposé le guide d'ondes. En outre, la face inférieure du guide d'ondes est connectée au support métallique, support métallique sur lequel est également disposé le substrat diélectrique. Dans cette configuration, le substrat diélectrique 20 est dans le prolongement du guide d'ondes 30.

Dans chacun des modes de réalisation ci-dessus décrit, la connexion électrique 50 réalisée sous la forme d'un conducteur métallique permet d'assurer la liaison électrique entre l'extrémité de la ligne de transmission 10 et l'entrée de la cavité 40 et est choisie pour être la plus transparente possible sur le plan électrique. Il peut s'agir, par exemple, d'un fil ou d'un ruban métallique de très petite longueur voire même, si la configuration le permet, d'un simple point de soudure.

Un prototype d'un dispositif de transition selon le premier mode de réalisation a été développé et caractérisé en bande X [8-12 GHz]. En particulier, des performances obtenues par simulation numérique ont été comparées au dispositif développé.

Pour pouvoir mesurer expérimentalement le dispositif, celui-ci est composé de deux transitions selon le premier mode de réalisation, montées en « tête-bêche » et séparées par un tronçon de guide d'ondes de longueur donnée.

Le guide d'ondes est ici dans un matériau de nature mousse polyuréthane de permittivité relative εᵣ = 1.17 et de pertes diélectriques tgδ = 0,003. Pour une transition unique, la longueur L de la cavité est légèrement inférieure à 0,6λ_{g}, où λ_{g} la longueur d'ondes guidée du signal dans un guide d'ondes fonctionnant en bande X, rempli de mousse. Cette longueur L permet de conserver un caractère relativement compact pour ce type de transition.

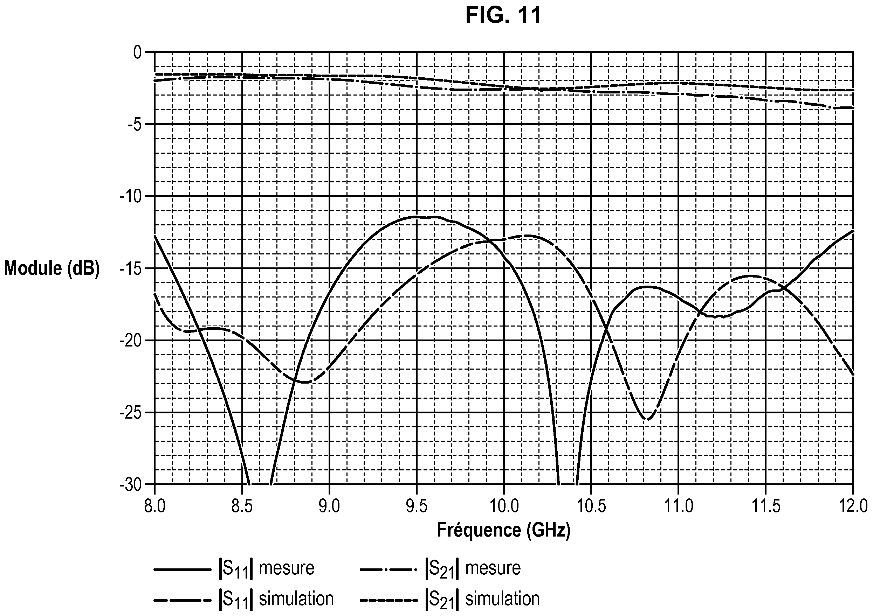

La **figure 11** illustre la comparaison entre mesures et simulations des coefficients de transmission et de réflexion du prototype fonctionnant en bande X. On constate, par cette figure, l'adéquation entre les différents résultats qui permet d'en déduire que le dispositif est bien adapté sur une large bande de fréquence (c'est-à-dire un niveau d'adaptation inférieur à -10dB sur une bande supérieure à [8-12GHz]) et que les pertes d'insertion pour la structure globale n'excèdent pas 2,5dB à la fréquence centrale de 10GHz et 4dB à la fréquence la plus élevée de 12GHz.

Ces résultats ramenés à une simple transition conduisent à un niveau d'adaptation bien inférieur à -10dB sur toute la bande X et à des pertes d'insertion à 10GHz bien inférieures à 1dB pour une transition élémentaire.

## Revendications

1. Dispositif de transition entre une ligne de transmission (10) imprimée sur un substrat diélectrique (20) et un guide d'ondes (30) rectangulaire comprenant une face avant (31) formant entrée du guide d'ondes (30), une face arrière (32) parallèle à la face avant (31) et formant sortie du guide d'ondes (30), une face inférieure (33), une face supérieure (34) parallèle à la face inférieure (33), les faces inférieure et supérieure s'étendant entre les faces avant (31) et arrière (32), le guide d'ondes (30) étant un bloc en matériau diélectrique dont les faces sont intégralement métallisées exceptées la face avant et la face arrière, le dispositif de transition comprenant :
une cavité tridimensionnelle (40) formée dans le volume du guide d'ondes (30) entre l'entrée (31) du guide d'ondes, formant en outre entrée de la cavité, et la face arrière (32) en s'évasant, la cavité étant à une hauteur d'entrée (H1) de la face inférieure (33) du guide d'ondes (30) et se terminant à une distance (L) de l'entrée de la cavité à une hauteur de sortie (H2) supérieure à la hauteur d'entrée (H1),
le dispositif de transition étant **caractérisé par** :
la cavité (40) présentant une largeur d'entrée (W1) et une largeur de sortie (W2) supérieure à la largeur d'entrée (W1) de sorte que l'évasement de la cavité conduit à ce que le long du guide d'ondes, le couple hauteur/largeur est croissant; et
une connexion électrique (50) s'étendant à partir de la ligne de transmission (10) le long de la face avant (31) du guide d'ondes jusqu'à l'entrée (31) de la cavité tridimensionnelle.

2. Dispositif selon la revendication précédente, dans lequel le substrat diélectrique (20) comprend une face avant (21) comprenant un dépôt conducteur (210) formant un plan de masse, et une face arrière (22) parallèle à la face avant sur laquelle la ligne de transmission (10) est imprimée, le guide d'ondes (30) étant disposé sur le plan de masse (210), le substrat diélectrique comprenant un évidement (23) configuré pour amener la connexion électrique (50) à l'entrée de la cavité (40), le guide d'ondes comprenant sur sa face inférieure une zone locale (37) au niveau de la connexion électrique dépourvue de métallisation afin d'empêcher tout contact électrique entre la connexion électrique et la face inférieure du guide d'ondes.

3. Dispositif selon la revendication 1, dans lequel le substrat diélectrique (20) comprend une face avant (21) comprenant un dépôt conducteur (210) formant un plan de masse, et une face arrière (22) parallèle à la face avant sur laquelle la ligne de transmission (10) est imprimée, le guide d'ondes étant disposé sur la face arrière (22), la face inférieure du guide d'ondes étant connectée au plan de masse par l'intermédiaire d'une pluralité de vias (70) métallisés traversant le substrat diélectrique (20), la face inférieure du guide d'ondes comprenant une zone locale (37) au niveau de la connexion électrique (50) dépourvue de métallisation afin d'empêcher tout contact électrique entre la connexion électrique et la face inférieure du guide d'ondes.

4. Dispositif selon la revendication 1, dans lequel le substrat diélectrique (20) comprend une face avant (21) sur laquelle sont imprimés la ligne de transmission (10) et un dépôt conducteur (210) formant plan de masse en contact avec la face inférieure du guide d'ondes, le plan de masse et la ligne de transmission étant coplanaires, la connexion électrique (50) étant connectée à l'extrémité de la ligne de transmission (10), la face inférieure du guide d'ondes comprenant une zone locale (37) au niveau de la connexion électrique dépourvue de métallisation afin d'empêcher tout contact électrique entre la connexion électrique et la face inférieure du guide d'ondes.

5. Dispositif selon la revendication 1, comprenant un support (22) métallique sur lequel est disposé le guide d'ondes (30), la face inférieure du guide d'ondes étant connectée audit support métallique, support métallique sur lequel est également disposé le substrat diélectrique, l'élément conducteur (50) étant connecté à l'entrée du guide d'ondes.

6. Dispositif de transition selon l'une des revendications précédentes, dans lequel la cavité tridimensionnelle comprend un profil d'entrée en entrée du guide d'ondes en forme de U.

7. Dispositif selon l'une des revendications 1 à 5, dans lequel la cavité tridimensionnelle comprend un profil d'entrée à bords linéaires obliques, à bords concaves, à bords convexes, à bords sinueux.

8. Dispositif selon l'une des revendications 1 à 7, dans lequel la cavité tridimensionnelle présente un profil d'évasement linéaire, concave, convexe, sinueux, ledit profil d'évasement étant caractéristique de la variation de la largeur de la cavité entre la largeur d'entrée et la largeur de sortie.

9. Dispositif selon l'une des revendications 1 à 8, dans la cavité tridimensionnelle comprend un profil latéral linéaire, concave, convexe, sinueux, ledit profil latéral étant caractéristique de la variation de la hauteur de la cavité entre la hauteur d'entrée et la hauteur de sortie.

## Patentansprüche

1. Vorrichtung für den Übergang zwischen einer auf ein dielektrisches Substrat (20) aufgedruckten Übertragungsleitung (10) und einem rechteckigen Wellenleiter (30), die Folgendes umfasst: eine Frontseite (31), die einen Eingang des Wellenleiters (30) bildet, eine Rückseite (32) parallel zur Frontseite (31), die den Ausgang des Wellenleiters (30) bildet, eine Unterseite (33), eine Oberseite (34) parallel zur Unterseite (33), wobei die Unter- und die Oberseite zwischen der Frontseite (31) und der Rückseite (32) verlaufen, wobei der Wellenleiter (30) ein dielektrischer Materialblock ist, dessen Seiten einstückig metallisiert sind, mit Ausnahme der Frontseite und der Rückseite, wobei die Übergangsvorrichtung Folgendes umfasst:
einen dreidimensionalen Hohlraum (40), ausgebildet im Volumen des Wellenleiters (30) zwischen dem Eingang (31) des Wellenleiters, der ferner einen Eingang des Hohlraums bildet, und die Rückseite (32), während er sich erweitert, wobei der Hohlraum sich in einer Eingangshöhe (H1) der Unterseite (33) des Wellenleiters (30) befindet und in einem Abstand (L) vom Eingang des Hohlraums in einer Ausgangshöhe (H2) über der Eingangshöhe (H1) endet,
wobei die Übergangsvorrichtung **dadurch gekennzeichnet ist, dass**:
der Hohlraum (40) eine Eingangsbreite (W1) und eine Ausgangsbreite (W2) hat, die größer ist als die Eingangsbreite (W1), so dass die Erweiterung des Hohlraums dazu führt, dass das Höhe/Breite-Paar entlang dem Wellenleiter zunimmt; und
eine elektrische Verbindung (50), die ausgehend von der Übertragungsleitung (10) entlang der Frontseite (31) des Wellenleiters bis zum Eingang (31) des dreidimensionalen Hohlraums verläuft.

2. Vorrichtung nach dem vorherigen Anspruch, bei der das dielektrische Substrat (20) eine Frontseite (21), die eine leitende Beschichtung (210) aufweist, die eine Masseebene bildet, und eine Rückseite (22) parallel zur Frontseite aufweist, auf der die Übertragungsleitung (10) aufgedruckt ist, wobei der Wellenleiter (30) auf der Masseebene (210) angeordnet ist, wobei das dielektrische Substrat eine Aussparung (23) aufweist, konfiguriert zum Führen der elektrischen Verbindung (50) zum Eingang des Hohlraums (40), wobei der Wellenleiter auf seiner Unterseite eine lokale Zone (37) ohne Metallisierung an der elektrischen Verbindung aufweist, um einen elektrischen Kontakt zwischen der elektrischen Verbindung und der Unterseite des Wellenleiters zu verhüten.

3. Vorrichtung nach Anspruch 1, bei der das dielektrische Substrat (20) eine Frontseite (21), die eine leitende Beschichtung (210) aufweist, die eine Masseebene bildet, und eine Rückseite (22) parallel zur Frontseite aufweist, auf der die Übertragungsleitung (10) aufgedruckt ist, wobei der Wellenleiter auf der Rückseite (22) angeordnet ist, wobei die Unterseite des Wellenleiters mit der Masseebene durch mehrere Durchkontaktierungen (70) verbunden ist, die durch das dielektrische Substrat (20) metallisiert sind, wobei die Unterseite des Wellenleiters eine lokale Zone (37) ohne Metallisierung an der elektrischen Verbindung (50) aufweist, um einen elektrischen Kontakt zwischen der elektrischen Verbindung und der Unterseite des Wellenleiters zu verhüten.

4. Vorrichtung nach Anspruch 1, bei der das dielektrische Substrat (20) eine Frontseite (21), auf der die Übertragungsleitung (10) aufgedruckt ist, und eine leitende Beschichtung (210) aufweist, die eine Masseebene in Kontakt mit der Unterseite des Wellenleiters bildet, wobei die Masseebene und die Übertragungsleitung koplanar sind, wobei die elektrische Verbindung (50) mit dem Ende der Übertragungsleitung (10) verbunden ist, wobei die Unterseite des Wellenleiters eine lokale Zone (37) ohne Metallisierung an der elektrischen Verbindung aufweist, um einen elektrischen Kontakt zwischen der elektrischen Verbindung und der Unterseite des Wellenleiters zu verhüten.

5. Vorrichtung nach Anspruch 1, die einen metallischen Träger (22) umfasst, auf dem der Wellenleiter (30) angeordnet ist, wobei die Unterseite des Wellenleiters mit dem metallischen Träger verbunden ist, wobei auf dem metallischen Träger auch das dielektrische Substrat angeordnet ist, wobei das leitende Element (50) mit dem Eingang des Wellenleiters verbunden ist.

6. Übergangsvorrichtung nach einem der vorherigen Ansprüche, in der der dreidimensionale Hohlraum ein Eingangsprofil am Eingang des Wellenleiters in Form eines U aufweist.

7. Vorrichtung nach einem der Ansprüche 1 bis 5, bei der der dreidimensionale Hohlraum ein Eingangsprofil mit schrägen linearen Rändern, konkaven Rändern, konvexen Rändern, sinusförmigen Rändern umfasst.

8. Vorrichtung nach einem der Ansprüche 1 bis 7, bei der der dreidimensionale Hohlraum ein lineares, konkaves, konvexes, sinusförmiges Erweiterungsprofil aufweist, wobei das Erweiterungsprofil für die Variation der Breite des Hohlraums zwischen der Eingangsbreite und der Ausgangsbreite charakteristisch ist.

9. Vorrichtung nach einem der Ansprüche 1 bis 8, wobei der dreidimensionale Hohlraum ein lineares, konkaves, konvexes, sinusförmiges Seitenprofil umfasst, wobei das Seitenprofil für die Variation der Höhe des Hohlraums zwischen der Eingangshöhe und der Ausgangshöhe charakteristisch ist.

## Claims

1. Transition device between a transmission line (10) which is printed on a dielectric substrate (20) and a rectangular waveguide (30) which comprises a front face (31) and which forms an input of the waveguide (30), a rear face (32) which is parallel with the front face (31) and which forms an output of the waveguide (30), a lower face (33), an upper face (34) parallel with the lower face (33), the lower and upper faces extending between the front face (31) and rear face (32), the waveguide (30) being a block of dielectric material, the faces of which are integrally metal-coated except for the front face and the rear face, the transition device comprising:
a three-dimensional cavity (40) which is formed in the volume of the waveguide (30) between the input (31) of the waveguide, further forming an input of the cavity, and the rear face (32) while widening, the cavity being at an input height (H1) of the lower face (33) of the waveguide (30) and terminating at a distance (L) from the input of the cavity at an output height (H2) which is greater than the input height (H1),
the transition device being **characterised by**:
the cavity (40) having an input width (W1) and an output width (W2) greater than the input width (W1) so that the widening of the cavity leads to the height/width pair increasing along the waveguide; and
an electrical connection (50) which extends from the transmission line (10) along the front face (31) of the waveguide as far as the input (31) of the three-dimensional cavity.

2. Device according to the preceding claim, wherein the dielectric substrate (20) comprises a front face (21) comprising a conductive deposit (210) which forms a floorplan and a rear face (22) which is parallel with the front face on which the transmission line (10) is printed, the waveguide (30) being arranged on the floorplan (210), the dielectric substrate comprising a recess (23) which is configured to bring the electrical connection (50) to the input of the cavity (40), the waveguide comprising on the lower face thereof a local zone (37) in the region of the electrical connection without any metal coating in order to prevent any electrical contact between the electrical connection and the lower face of the waveguide.

3. Device according to claim 1, wherein the dielectric substrate (20) comprises a front face (21) comprising a conductive deposition (210) forming a floorplan and a rear face (22) parallel with the front face, on which the transmission line (10) is printed, the waveguide being arranged on the rear face (22), the lower face of the waveguide being connected to the floorplan by means of a plurality of metal-coated vias (70) which extend through the dielectric substrate (20), the lower face of the waveguide comprising a local zone (37) in the region of the electrical connection (50) without any metal coating in order to prevent any electrical contact between the electrical connection and the lower face of the waveguide.

4. Device according to claim 1, wherein the dielectric substrate (20) comprises a front face (21) on which there are printed the transmission line (10) and a conductive deposition (210) forming a floorplan in contact with the lower face of the waveguide, the floorplan and the transmission line being co-planar, the electrical connection (50) being connected to the end of the transmission line (10), the lower face of the waveguide comprising a local zone (37) in the region of the electrical connection without any metal coating in order to prevent any electrical contact between the electrical connection and the lower face of the waveguide.

5. Device according to claim 1, comprising a metal support (22) on which the waveguide (30) is arranged, the lower face of the waveguide being connected to the metal support, on which metal support there is also arranged the dielectric substrate, the conductive element (50) being connected to the input of the waveguide.

6. Transition device according to any one of the preceding claims, wherein the three-dimensional cavity comprises an input profile at the input of the waveguide in the form of aU.

7. Device according to any one of claims 1 to 5, wherein the three-dimensional cavity comprises an input profile with oblique linear edges, concave edges, convex edges, sinuous edges.

8. Device according to any one of claims 1 to 7, wherein the three-dimensional cavity has a linear, concave, convex, sinuous widening profile, the widening profile being characteristic of the variation of the width of the cavity between the input width and the output width.

9. Device according to any one of claims 1 to 8, wherein the three-dimensional cavity comprises a linear, concave, convex, sinuous lateral profile, the lateral profile being characteristic of the variation of the height of the cavity between the input height and the output height.
